# EUROPÄISCHE PATENTANMELDUNG

(11) **EP 0 773 587 A2**
(43) Veröffentlichungstag der Anmeldung: **14.05.1997**
(21) Anmeldenummer: 96810693.0
(22) Anmeldetag: 14.10.1996
(51) Int. Cl.: H01L 25/065, H01L 25/07, H01L 21/98

(54) **Verfahren zum Herstellen eines Leistingshalbleitermoduls**

(30) Priorität: 13.11.1995 US 558022
(71) Anmelder: ASEA BROWN BOVERI AG, 5400 Baden (CH)
(72) Erfinder: Bayerer, Reinhold, Dr., 64385 Reichelsheim (DE)

(57) **Zusammenfassung**

Bei einem Verfahren zum Herstellen eines Leistungshalbleitermoduls (10), bei welchem auf einer gemeinsamen Unterlage (11) eine Mehrzahl von Submodulen (12) angeordnet und mittels einer Mehrschichtverbundes aus abwechselnd übereinander geschichteten Metallagen (13-15) und Isolierlagen (16, 17) untereinander verbunden und nach aussen hin anschliessbar sind, wird eine sichere Herstellung des Schichtverbundes dadurch erreicht, dass zum Aufbau des Schichtverbundes die einzelnen Metallagen (13-15) und Isolierlagen (16, 17) übereinandergestapelt, mittels Justierhilfsmitteln (18, 19) untereinander und gegenüber der Unterlage (11) ausgerichtet und im ausgerichteten Zustand untereinander stoffschlüssig verbunden werden.

## Beschreibung

### TECHNISCHES GEBIET

Die vorliegende Erfindung bezieht sich auf das Gebiet der Leistungselektronik. Sie betrifft ein Verfahren zum Herstellen eines Leistungshalbleitermoduls, bei welchem auf einer gemeinsamen Unterlage eine Mehrzahl von Submodulen angeordnet und mittels einer Mehrschichtverbundes aus abwechselnd übereinander geschichteten Metallagen und Isolierlagen untereinander verbunden und nach aussen hin anschliessbar sind.

### STAND DER TECHNIK

Ein solches Verfahren ist z.B. aus der Druckschrift EP-A1-0 597 144 bekannt.

Module gemäss der eingangs genannten Druckschrift sind aus einzelnen Submodulen aufgebaut, die untereinander und nach aussen hin durch eine Schichtenfolge aus im wesentlichen ebenen Isolierlagen, leitenden Blechen bzw. Metallagen sowie Kühlkörpern und anderen Zusatzelementen elektrisch und thermisch verbunden sind. Diese verschiedenen Schichten sind auf einer Unterlage abwechselnd aufeinandergestapelt und werden z.B. durch Verkleben zu einem festen Schichtverbund zusammengefügt. Der Klebstoff wird durch Dispersion, Siebdrucken oder ähnliche Verfahren auf die Klebeflächen der zu verklebenden Schichten aufgetragen. Die Schichten werden dann mit dem noch flüssigen Kleber aufeinander gestapelt. Danach erfolgt die Aushärtung.

Problematisch ist dabei, dass die einzelnen Schichten mit dem noch flüssigen Kleber beim Aufeinanderstapeln verrutschen können, so dass die Kontaktierung der Halbleiterelemente verschmutzt werden kann, und sich die äusseren Kontakte nicht mehr in der gewünschten Position befinden.

### DARSTELLUNG DER ERFINDUNG

Es ist daher Aufgabe der Erfindung, ein Verfahren zur Herstellung eines solchen Leistungshalbleitermoduls anzugeben, bei dem die Fertigstellung des Schichtverbundes ohne ein Verrutschen der einzelnen Schichten auf einfache Weise sichergestellt ist.

Die Aufgabe wird bei einem Verfahren der eingangs genannten Art dadurch gelöst, dass zum Aufbau des Schichtverbundes die einzelnen Metallagen und Isolierlagen übereinandergestapelt, mittels Justierhilfsmitteln untereinander und gegenüber der Unterlage ausgerichtet und im ausgerichteten Zustand untereinander stoffschlüssig verbunden werden. Der Einsatz von Justierhilfsmitteln ermöglicht eine sichere und dauerhafte Ausrichtung der Schichten während des Verbindens, ohne dass die Schichten selbst wesentlich verändert werden müssen. Darüber hinaus ist es möglich, die Justierhilfsmittel entfernbar auszugestalten, so dass sie nach Fertigstellung des Verbundes entfernt werden können, und den weiteren Modulaufbau nicht stören.

Gemäss einem ersten bevorzugten Ausführungsbeispiel des erfindungsgemässen Verfahrens sind die Justierhilfsmittel an den Seitenrändern des Schichtverbundes angeordnet, und sind weiterhin die Metallagen an den Seitenrändern, an denen die Justierhilfsmittel angeordnet sind, gegenüber den benachbarten Isolierlagen zurückspringend ausgebildet, und umfassen die Justierhilfsmittel zusätzliche Mittel, welche eine Justierung der zurückspringenden Metallagen an den randseitigen Justierhilfsmitteln ermöglichen. Durch die Anordnung der Justierhilfsmittel an den Rändern, wird die Störung des Schichtverbundes durch die Justierhilfsmittel gering gehalten. Das Zurückspringen der Metallagen und deren Justierung durch die zusätzlichen Mittel gewährleisten eine hohe randseitige Isolation (Spannungsfestigkeit > 1000 V) zwischen den auf verschiedenen Potentialen befindlichen Schichten, wie dies für Leistungshalbleitermodule unabdingbar ist.

Eine weitere bevorzugte Ausführungsform des Verfahrens nach der Erfindung ist dadurch gekennzeichnet, dass Justierhilfsmittel verwendet werden, welche nach Fertigstellung des Schichtverbundes entfernt werden können. Auf diese Weise sind im fertigen Modul keine störenden zusätzlichen Justierteile vorhanden.

Besonders einfach lassen sich entfernbare Justierhilfsmittel realisieren, wenn gemäss einer weiteren Ausführungsform die Justierhilfsmittel Justierstifte umfassen, welche in entsprechende Bohrungen in der Unterlage einsteckbar sind, und wenn die zusätzlichen Mittel Distanzscheiben umfassen, welche auf die Justierstifte aufsteckbar sind, und welche eine Dicke aufweisen, die ungefähr gleich der Dicke der zugehörigen Metallagen ist.

Alternativ können aber auch Justiermittel verwendet werden, welche fest mit der Unterlage verbunden sind und damit fest im fertigen Modul integriert bleiben, wobei insbesondere an der Unterlage vertikale Seitenwände angebracht sind, und die Justiermittel vertikale Justierstege umfassen, welche an der Innenseite der Seitenwände angebracht sind.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in perspektivischer, halboffener Darstellung ein erstes bevorzugtes Ausführungsbeispiel für ein Leistungshalbleitermodul mit entfernbaren Justierhilfsmitteln zur Herstellung des Schichtverbundes; und
- Fig. 2: in einer vergleichbaren Darstellung ein zweites bevorzugtes Ausführungsbeispiel eines Leistungshalbleitermoduls mit fest integrierten Justierhilfsmitteln.

### WEGE ZUR AUSFÜHRUNG DER ERFINDUNG

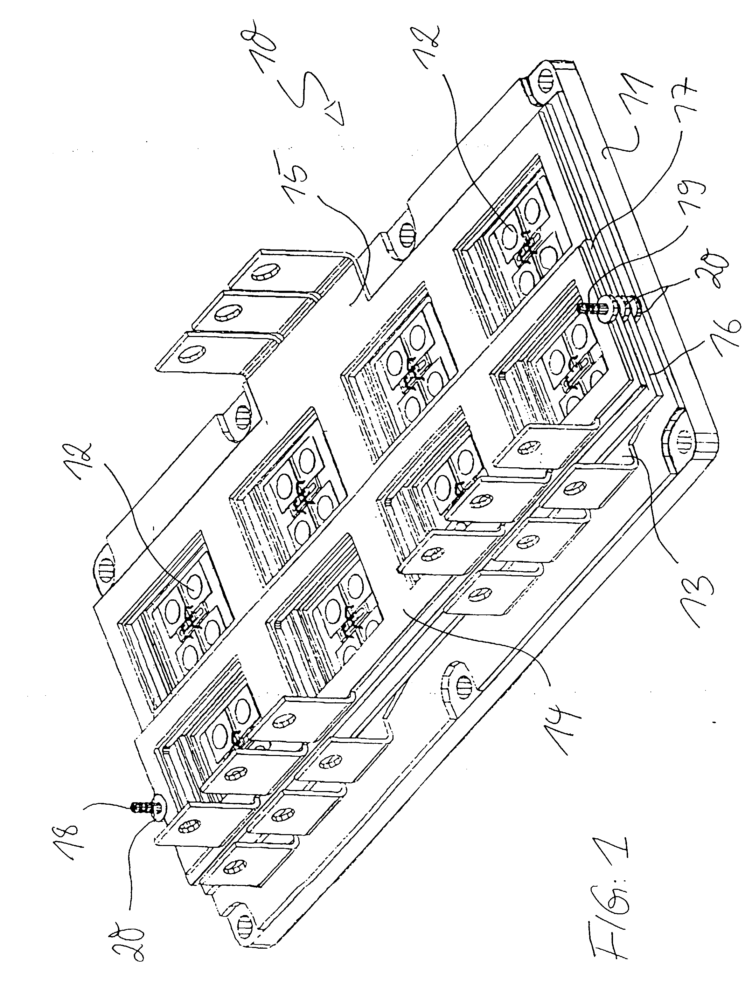

In Fig. 1 ist in perspektivischer, halboffener Darstellung ein Ausführungsbeispiel für ein Leistungshalbleitermodul im Spannnungsbereich 2500 V mit entfernbaren Justierhilfsmitteln wiedergegeben. Das Leistungshalbleitermodul 10 umfasst auf einer gemeinsamen Bodenplatte 11 (aus Cu) eine Mehrzahl von nebeneinander angeordneten Submodulen 12, die untereinander und nach aussen hin durch einen Schichtverbund aus mehreren Metallagen 13, 14 und 15 und dazwischenliegenden Isolierlagen 16, 17 verbunden bzw. anschliessbar sind. Der Anschluss von aussen erfolgt über entsprechende nach oben gebogene Mehrfachlaschen, die an den Metallagen 13, 14 und 15 angeformt sind. Die Submodule 12 enthalten ihrerseits einzelne Halbleiterelemente wie z.B. IGBTs oder Dioden in Chipform, die untereinander verbunden und an den Schichtverbund angeschlossen sind.

An den Querrändern des Schichtverbundes sind in der Bodenplatte 11 (in Fig. 1 nicht sichtbare) Bohrlöcher angeordnet, in welche zwei Justierstifte 18, 19 eingesteckt oder -gepresst sind. Die Justierstifte sind aus einem Kunststoffmaterial (z.B. Teflon, Delrin o.ä.), an welchem der für die Herstellung des Schichtverbundes verwendete Klebstoff nicht haften kann. Die Justierstifte können so nach Aushärtung der Klebungen leicht aus den Bohrlöchern in der Bodenplatte 11 herausgezogen werden und stören dadurch nicht die weitere Vollendung des Moduls.

Die Isolierlagen 16 und 17 liegen mit ihren Seitenrändern direkt im Bereich der Justierstifte 18, 19. Sie sind an diesen Stellen mit im Durchmesser angepassten Löchern oder U-förmigen Ausschnitten versehen, so dass sie mit ihren Rändern über die Justierstifte 18, 19 rutschen können und von den Justierstiften 18, 19 in Position gehalten werden. Da die Metallagen 13, 14, 15 zur Sicherstellung der Isolation gegenüber hohen Spannungen (> 1000 V) überall um ca. 1 mm von gegenüber der Kante der Isolierlagen 16, 17 zurückspringen müssen, können diese nicht direkt von den (relativ dünnen) Justierstiften 18, 19 geführt werden. Für die Justierung der Metallagen 13-15 werden daher in deren Ränder im Bereich der Justierstifte 18, 19 Löcher oder U-förmige Ausschnitte eingebracht, die im Durchmesser 2 mm grösser sind. Die Justierung der Metallagen erfolgt dann über zusätzliche Mittel in Form von über die Justierstifte 18, 19 geschobenen Distanzscheiben 20. Die Distanzscheiben sind vorzugsweise aus dem gleichen Material wie die Justierstifte 18, 19. Sie weisen ungefähr dieselbe Dicke auf wie die Metallagen und sind den Löchern bzw. U-förmigen Ausschnitten in den Metallagen im Durchmesser angepasst. Auf diese Weise lassen sich nun mehrere Isolierlagen 16, 17 und Metallagen 13-15 in abwechselnder Weise aufeinander stapeln und justieren.

Nach dem Aushärten der Verklebung werden die Justierstifte 18, 19 dann aus der Bodenplatte 11 herausgezogen. Damit werden auch die Distanzscheiben 20 frei und können entfernt werden. Durch die Entfernung der Justierstifte 18, 19 und Distanzscheiben 20 wird der Justierbereich frei für das Vergiessen des Moduls. Damit ist sichergestellt, dass die Isolation im Randbereich gewährleistet ist.

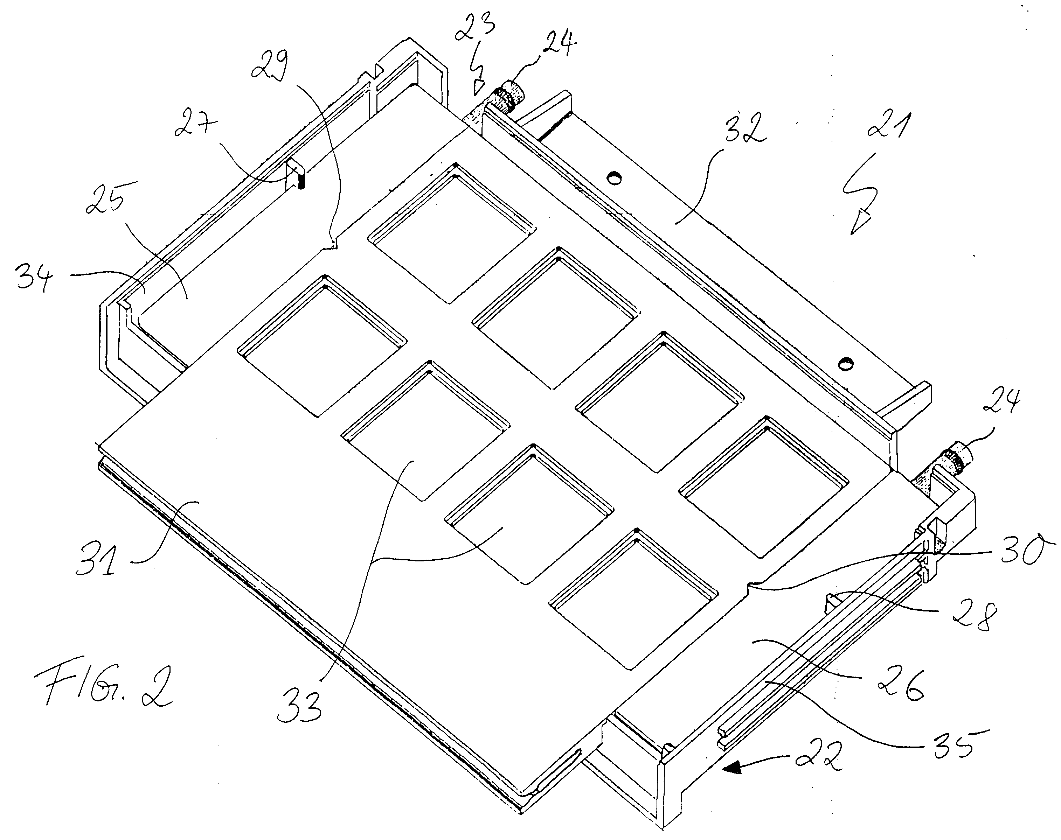

Ein weiteres Ausführungsbeispiel in Form eines Moduls mit fest integrierten Justierhilfsmitteln ist in Fig. 2 gezeigt. Das Leistungshalbleitermodul 21, das für eine Spannung von 4500 V ausgelegt ist, ist im Inneren so aufgebaut, dass die untere Hälfte des Moduls, das Unterteil 22 mit der angeformten Befestigungsleiste 32, gleichzeitig als Träger für die Montage der Lagen bzw. Schichten aufeinander dient. Das Unterteil 22 weist an den Querseiten vertikale Seitenwände 34, 35 auf, an deren Innenseite vertikale Justierstege 27, 28 angeformt sind. Die Justierstege 27, 28 passen zu entsprechenden Aussparungen in dem (unten) eingebauten Kühler 23 (mit seinen Kühleranschlüssen 24) und den (in Fig. 2 nicht gezeigten) Isolierlagen. Der Kühler 23, die Isolierlagen und die (ebenfalls nicht gezeigte) oberste Leiterplatte zur Verdrahtung der Hilfsanschlüsse sind durch die Justierstege 27, 28 direkt justiert.

Die Metallagen (eine Metallage 31 mit Aussparungen 33 für die Submodule ist in Fig. 2 gezeigt) werden wiederum mit Distanz zu den Kanten der Isolierlagen eingebaut. Um deren Justierung dennoch zu gewährleisten, sind als zusätzliche Mittel flache, plattenförmige Distanzstücke 25, 26 (2 je Metallage) aus isolierendem Material vorgesehen, die auf ihren Aussenkanten wie die Isolierlagen Aussparungen passend zu den Justierstegen 27, 28 an den Seitenwänden 34, 35 haben. An ihren Innenkanten führen die Distanzstücke 25, 26 die Metallagen 31 mittels weiterer Justiermarken. So können beispielsweise - wie in Fig. 2 gezeigt - an den Innenrändern der Distanzstücke 25, 26 Justierzungen 29, 30 angeformt sein, die in entsprechende Aussparungen an den Seitenrändern der Metallagen 31 eingreifen. Es kann aber auch in Umkehrung so sein, dass an den Rändern der Metallagen die Justierzungen, und an den Innenkanten der Distanzstücke 25, 26 die zugehörigen Aussparungen angeordnet sind.

Die Distanzstücke 25, 26 haben ungefähr die gleiche Dicke wie die zugehörigen Metallagen und liegen mit ihnen auf derselben Ebene. Sie bleiben - ebenso wie die Justierstege 27, 28 - im Modul eingebaut und sind mit den anderen Teilen so verklebt, dass kein Kriechweg von Metallage zu Metallage bei unterschiedlichen Potentialen besteht. Auch in diesem Fall ist also sichergestellt, dass die einzelnen Schichten des herzustellenden Schichtverbundes bis zur Aushärtung justiert und fixiert bleiben.

### BEZEICHNUNGSLISTE

- 10,21: Leistungshalbleitermodul
- 11: Bodenplatte
- 12: Submodul
- 13,14,15: Metallage
- 16,17: Isolierlage
- 18,19: Justierstift
- 20: Distanzscheibe
- 22: Unterteil
- 23: Kühler
- 24: Kühleranschluss
- 25,26: Distanzstück
- 27,28: Justiersteg
- 29,30: Justierzunge
- 31: Metallage
- 32: Befestigungsleiste
- 33: Aussparung (für Submodul)
- 34,35: Seitenwand

## Patentansprüche

1. Verfahren zum Herstellen eines Leistungshalbleitermoduls (10, 21), bei welchem auf einer gemeinsamen Unterlage (11, 22) eine Mehrzahl von Submodulen (12) angeordnet und mittels einer Mehrschichtverbundes aus abwechselnd übereinander geschichteten Metallagen (13-15; 31) und Isolierlagen (16, 17) untereinander verbunden und nach aussen hin anschliessbar sind, dadurch gekennzeichnet, dass zum Aufbau des Schichtverbundes die einzelnen Metallagen (13-15; 31) und Isolierlagen (16, 17) übereinandergestapelt, mittels Justierhilfsmitteln (18, 19; 27, 28; 29, 30) untereinander und gegenüber der Unterlage (11, 22) ausgerichtet und im ausgerichteten Zustand untereinander stoffschlüssig verbunden werden.

2. Verfahren nach Anspruch 1, dadurch gekennzeichnet, dass die Justierhilfsmittel (18, 19; 27, 28; 29, 30) an den Seitenrändern des Schichtverbundes angeordnet sind.

3. Verfahren nach Anspruch 2, dadurch gekennzeichnet, dass die Metallagen (13-15; 31) an den Seitenrändern, an denen die Justierhilfsmittel (18, 19; 27, 28; 29, 30) angeordnet sind, gegenüber den benachbarten Isolierlagen (16, 17) zurückspringend ausgebildet sind, und dass die Justierhilfsmittel (18, 19; 27, 28; 29, 30) zusätzliche Mittel (20; 25, 26) umfassen, welche eine Justierung der zurückspringenden Metallagen (13-15; 31) an den randseitigen Justierhilfsmitteln (18, 19; 27, 28; 29, 30) ermöglichen.

4. Verfahren nach Anspruch 4, dadurch gekennzeichnet, dass Justierhilfsmittel (18, 19) verwendet werden, welche nach Fertigstellung des Schichtverbundes entfernt werden können.

5. Verfahren nach Anspruch 4, dadurch gekennzeichnet, dass die Justierhilfsmittel Justierstifte (18, 19) umfassen, welche in entsprechende Bohrungen in der Unterlage (11) einsteckbar sind.

6. Verfahren nach Anspruch 5, dadurch gekennzeichnet, dass die zusätzlichen Mittel Distanzscheiben (20) umfassen, welche auf die Justierstifte (18, 19) aufsteckbar sind, und welche eine Dicke aufweisen, die ungefähr gleich der Dicke der zugehörigen Metallagen (13, 14, 15) ist.

7. Verfahren nach Anspruch 3, dadurch gekennzeichnet, dass Justiermittel (27, 28) verwendet werden, welche fest mit der Unterlage (22) verbunden sind.

8. Verfahren nach Anspruch 7, dadurch gekennzeichnet, dass an der Unterlage (22) vertikale Seitenwände (34, 35) angebracht sind, und dass die Justiermittel vertikale Justierstege (27, 28) umfassen, welche an der Innenseite der Seitenwände (34, 35) angebracht sind.

9. Verfahren nach Anspruch 8, dadurch gekennzeichnet, dass die zusätzlichen Mittel plattenförmige Distanzstücke (25, 26) umfassen, welche eine Dicke aufweisen, die ungefähr gleich der Dicke der zugehörigen Metallagen (31) ist.
